# EUROPEAN PATENT APPLICATION

(11) **EP 4 345 861 A1**
(43) Date of publication of application: **03.04.2024**
(21) Application number: 22198397.6
(22) Date of filing: 28.09.2022
(51) Int. Cl.: H01J 37/20

(54) **CHARGED PARTICLE APPARATUS**

(71) Applicant: ASML Netherlands B.V., 5500 AH Veldhoven (NL)
(72) Inventor: KUIPER, Vincent, Sylvester, 5500 AH Veldhoven (NL); SCOTUZZI, Marijke, 5500 AH Veldhoven (NL)
(74) Representative: ASML Netherlands B.V.

(57) **Abstract**

The present invention provides a charged particle apparatus for projecting multiple beam grids of charged particle beams towards a plurality of samples. The apparatus comprises: a stage configured to support a plurality of samples at respective sample positions; and an array of charged particle devices respectively configured to project a plurality of charged particle beams in a beam grid towards the respective the sample positions. The charged particle devices respectively comprise: an objective lens configured to direct the beam grid of the charged particle device on a sample at the respective sample position; and a detector configured to detect signal particles from the sample. The stage is configured to be actuated relative to the array of charged particle devices. The stage and the array of charged particle devices are configured such that the array of charged particle devices scan relative to the plurality of samples simultaneously.

## Description

### FIELD

The embodiments provided herein generally relate to charged particle apparatus.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment, e.g., inspection and/or measurement, of a surface of a substrate, or other object/material, is an important process during and/or after its manufacture.

Pattern assessment systems with a charged particle beam have been used to inspect objects, for example to detect pattern defects and to measure structural features on such objects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over, or across, the sample surface, secondary electrons can be emitted across the surface of the sample. By collecting these emitted secondary electrons from the sample surface, a pattern assessment system (or assessment tool) may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

There is a desire to increase the throughput of the assessment systems, such as for inspection, such that samples can be processed more quickly. In particular, there is a desire to increase throughput to one wafer per hour. One technique to increase the throughput of assessment systems is to increase the number of charged particle devices, otherwise referred to as columns, positioned to scan each sample. However, there remains a problem that there is limited space in the assessment system, for example the assessment apparatus part of the assessment system, which in use may be situated in production hall of a chip fabrication facility, meaning there is a limit to the number of charged particle devices that can be positioned to scan a sample of a typical size. The present invention therefore aims to increase throughput of samples.

### SUMMARY

It is an object of the present disclosure to provide embodiments of charged particle apparatus.

According to a first aspect of the invention, there is provided a charged particle apparatus for projecting multiple beam grids of charged particle beams towards a plurality of samples. The apparatus comprises a stage and an array of charged particle devices. The stage is configured to support a plurality of samples at respective sample positions. The charged particle devices are respectively configured to project a plurality of charged particle beams in a beam grid towards the respective the sample positions. The charged particle devices respectively comprise an objective lens and a detector. The objective lens is configured to direct the beam grid of the charged particle device on a sample at the respective sample position, and the detector is configured to detect signal particles from the sample. The stage is configured to be actuated relative to the array of charged particle devices. The stage and the array of charged particle devices are configured such that the array of charged particle devices scan relative to the plurality of samples simultaneously.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam assessment apparatus.
**FIG. 2** is a schematic diagram illustrating an exemplary multi-beam charged particle assessment system that is part of the exemplary electron beam assessment apparatus of **FIG. 1****.**
**FIG. 3** is a schematic diagram of an exemplary multi-beam charged particle device.
**FIG. 4** is a schematic diagram of an exemplary charged particle device comprising a collimator element array and a scan-deflector array.
**FIG. 5** is a schematic diagram of an exemplary multi-beam charged particle device.
**FIG. 6** is a schematic diagram of a charged particle apparatus comprising a plurality of the charged particle devices of **FIG. 4****.**
**FIG. 7A-C** are schematic diagrams of exemplary embodiments of charged particle apparatus comprising different arrangements of arrays of charged particle devices and corresponding samples.
**FIG. 8A-B** are schematic diagrams providing different views of an exemplary stage comprising a coarse actuator, sub-stages and sample supports.
**FIG. 9** is a schematic diagram of an exemplary stage comprising a central sample support surrounded by other sample supports.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment systems (such as, or such as comprising, a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an assessment apparatus may utilize a single primary electron beam incident on a sample. For high throughput inspection, some of the assessment apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam assessment apparatus can therefore assess, for example inspect, a sample at a much higher speed than a single-beam assessment apparatus.

An implementation of known multi-beam assessment apparatus and systems is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

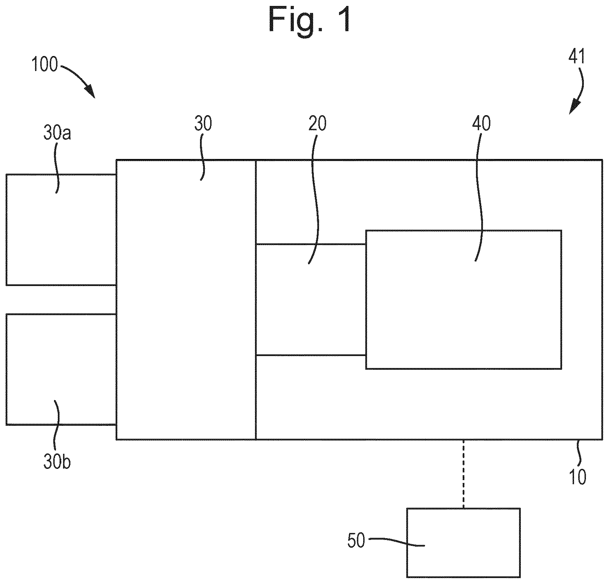

Reference is now made to **FIG. 1****,** which is a schematic diagram illustrating an exemplary charged particle beam assessment apparatus 100. It should be noted that the assessment apparatus comprises part of the assessment system, often the part of the assessment system situated in a fabrication facility, The assessment apparatus may cover a surface area of the fabrication facility floor referred to as an apparatus footprint. The other parts of the assessment system such as service systems of vacuum and fluid supplies and remote processing racks may be located elsewhere in the fabrication facility away from other fabrication systems and apparatus where space is a less significant requirement,

The charged particle beam assessment apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be assessed e.g. measured or inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be assessed. The charged particle assessment system 40 comprises a charged particle device 41. The charged particle device 41 may be an electron-optical device, which may be synonymous with the electron-optical system. The charged particle device 41 may be a multi-beam charged particle device 41 configured to project a multi-beam towards the sample, for example the sub-beams being arranged with respect to each other in a multi-beam arrangement. Alternatively, the charged particle device 41 may be a single beam charged particle device 41 configured to project a single beam towards the sample.

The controller 50 is electronically connected to the charged particle assessment system 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it can be distributed over at least two of the component elements. While the present disclosure provides examples of the main chamber 10 housing an electron beam assessment apparatus, it should be noted that aspects of the disclosure in their broadest sense are not limited to a chamber housing an electron beam assessment apparatus. Rather, it is appreciated that the foregoing principles may also be applied to other tools and other arrangements of apparatus, that operate under the second pressure.

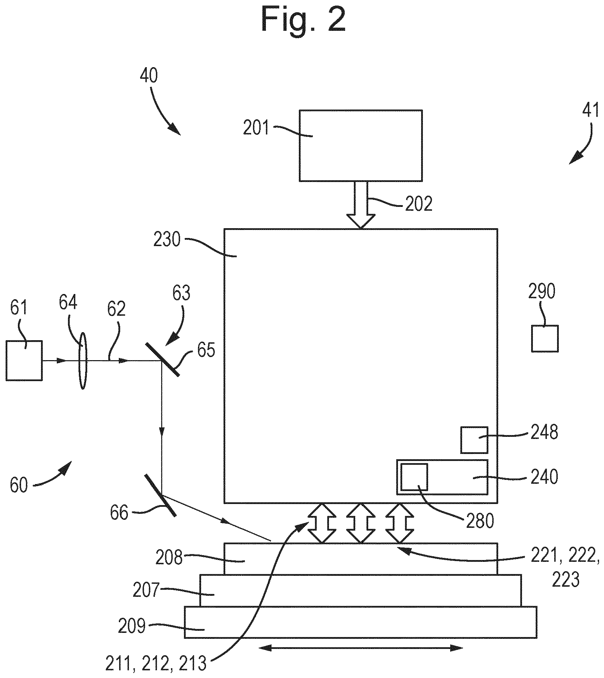

Reference is now made to **FIG. 2****,** which is a schematic diagram illustrating an exemplary charged particle assessment system 40 including a multi-beam charged particle device 41 that is part of the exemplary charged particle beam assessment apparatus 100 of **FIG. 1****.** The multi-beam charged particle device 41 comprises an electron source 201 and a projection apparatus 230. The charged particle assessment system 40 further comprises an actuated stage 209 and a sample holder 207. The sample holder may have a holding surface (not depicted) for supporting and holding the sample. Thus the sample holder may be configured to support the sample. Such a holding surface may be a electrostatic clamp operable to hold the sample during operation of the charged particle device 41 e.g. assessment such as measurement or inspection of at least part of the sample. The holding surface may be recessed into sample holder, for example a surface of the sample holder orientated to face the charged particle device 41. The electron source 201 and projection apparatus 230 may together be referred to as the charged particle device 41. The sample holder 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy ≤ 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2**). However, the signal processing system 280 may be incorporated into any components of the assessment apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle assessment system 40 and charged particle beam assessment apparatus 100 described above, are disclosed in US2020118784, US20200203116, US 2019/0259570 and US2019/0259564 which are hereby incorporated by reference.

As shown in **FIG. 2****,** in an embodiment the charged particle assessment system 40 has a single charged particle device 41 and optionally comprises a projection assembly 60. The projection assembly 60 may be a module and may be referred to as an ACC module. The projection assembly 60 is arranged to direct a light beam 62 such that the light beam 62 enters between the charged particle device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

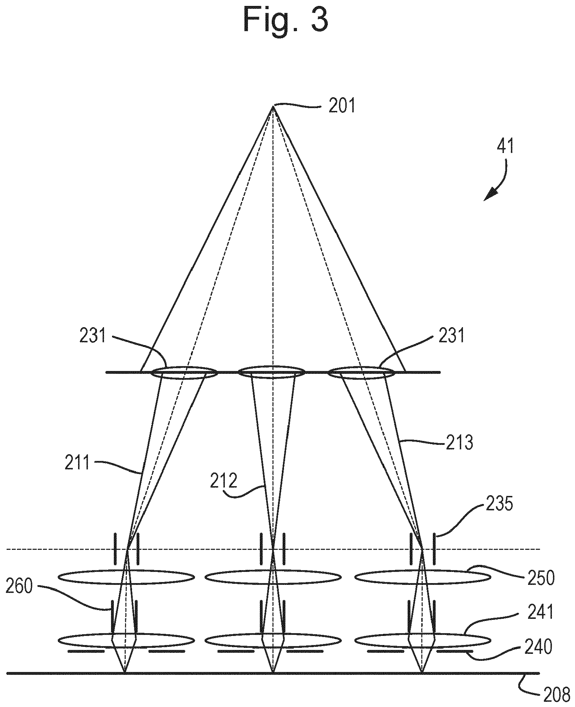

Components of a charged particle assessment system 40 which may be used in the present invention are described below in relation to **FIG. 3** which is a schematic diagram of a charged particle assessment system 40. The charged particle assessment system 40 of **FIG. 3** may correspond to the charged particle assessment system 40 (which may also be referred to as an apparatus or a tool) mentioned above.

The electron source 201 directs electrons toward an array of condenser lenses 231 (otherwise referred to as a condenser lens array). The electron source 201 is desirably a high brightness thermal field emitter arranged to operate within an optimized electron-optical performance range that is a compromise between brightness and total emission current (such a compromise may be considered to be a 'good' compromise'). The electron source emits a source beam. There may be many tens, many hundreds or many thousands, or even tens of thousands of condenser lenses 231. The condenser lenses 231 may comprise multi-electrode lenses and have a construction based on EP1602121A1, which document is hereby incorporated by reference in particular to the disclosure of a lens array to split a source beam into a plurality of sub-beams. An most up beam plate, which may be referred to as beam limiting aperture array, and which may be the most up beam plate of the condenser lens array, may generate the plurality of beams. The array condenser lenses (which may comprise the beam limiting aperture array) may provide a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens 231 in the array directs electrons into a respective sub-beam 211, 212, 213 which is focused at a respective intermediate focus downbeam of the condenser lens array. The sub-beams diverge with respect to each other. In an embodiment, deflectors 235 are provided at the intermediate focuses. The deflectors 235 are positioned in the sub-beam paths at, or at least around, the position of the corresponding intermediate points of focus. The deflectors 235 are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Downbeam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. In an embodiment of the arrangement, the collimator may comprise a macro collimator, instead of, or in addition to the deflectors 235. The macro-collimator may be electrostatic for example as two more planar plates with a single aperture.

Below (i.e. downbeam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching an objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. In an embodiment the control lenses of the control lens array may be considered to be part of the objective lenses of the objective lens array. The electrode plates of the control lens array may be considered electron-optically to be additional electrode plates of the objective lens array.

It is desirable to use the control lens array 250 to determine the landing energy. However, it is possible to use in addition the objective lens array 241 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned upbeam of the objective lens array 241.

The control lens array 250 comprises a control lens for each sub-beam 211, 212, 213. A function of the control lens array 250 is to optimize the beam opening angle with respect to the demagnification of the beam and/or to control the beam energy delivered to the objective lens array 241 which directs the sub-beams 211, 212, 213 onto the sample 208. The objective lens array 241 may be positioned at or near the base of the charged particle device 41. The control lens array 250 is optional, but is preferred for optimizing a sub-beam upbeam of the objective lens array. In an arrangement the control lens array 250 may be considered to be part of the objective lens array. The plates of the control lens array may be considered to be additional plates of the objective lens array. Within an objective lens array meeting this definition the function of the control lens array may be a function of the objective lens array in addition to the functions of the objective lens array herein described.

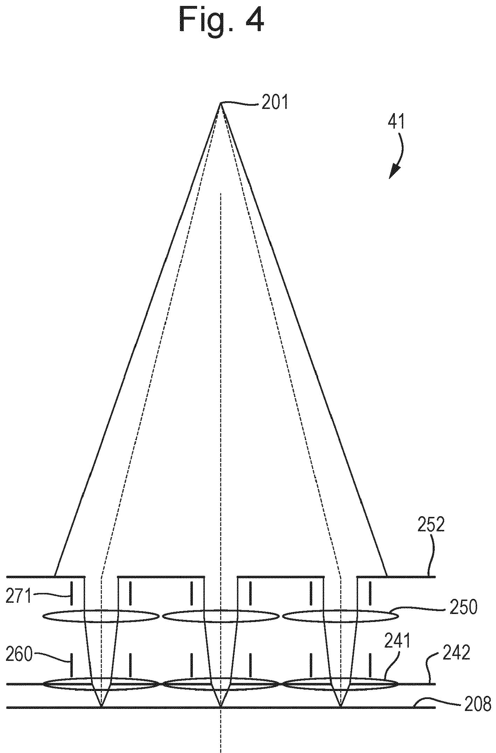

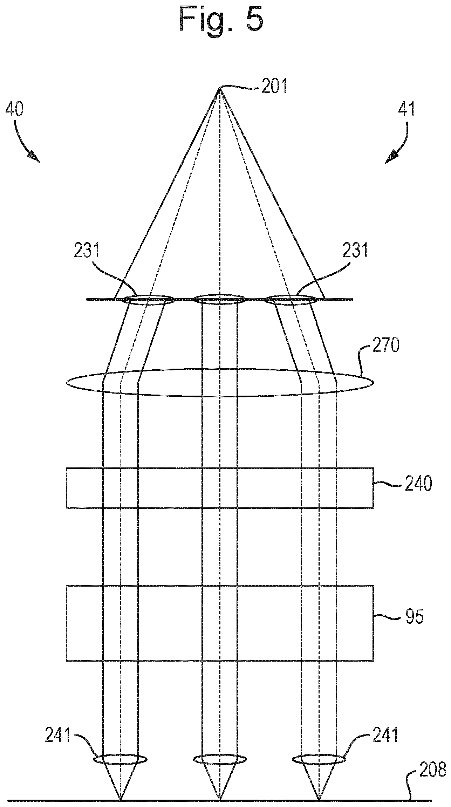

For ease of illustration, lens arrays are depicted schematically herein by arrays of oval shapes (as shown in **FIG. 3** and for that matter **FIGs 4** **and** **5**). Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

An array of scan deflectors 260 may be provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

The schematic diagram of an exemplary charged particle device, as shown in **FIG. 3** has an objective lens array assembly. The objective lens array assembly comprises the objective lens array 241. The objective lens array 241 comprises a plurality of objective lenses. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam or group of sub-beams in the multi-beam. Each plate defines a plurality of apertures (which may also be referred to as holes). The position of each aperture in a plate corresponds to the position of a corresponding aperture (or corresponding hole) in the other plate (or plates). The corresponding apertures define the objective lenses and each set of corresponding holes therefore operates in use on the same sub-beam or group of sub-beams in the multi-beam. Each objective lens projects a respective sub-beam of the multi-beam onto a sample 208.

The objective lens array assembly further comprises the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams. (e.g. apply a focusing action to the sub-beams prior to the sub-beams reaching the objective lens array 241). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations. In an embodiment, the control lens array may be considered to be part of the objective lens array.

In the arrangement of **FIG. 3****,** the objective lens array assembly comprises the scan-deflector array 260. The scan-deflector array 260 comprises a plurality of scan deflectors. The scan-deflector array 260 may be formed using MEMS manufacturing techniques. Each scan deflector scans a respective sub-beam over, or across, the sample 208. The scan-deflector array 260 may thus comprise a scan deflector for each sub-beam. Each scan deflector may deflect rays in the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. The scan-deflector array 260 is positioned between the objective lens array 241 and the control lens array 250. In the embodiment shown, the scan-deflector array 260 is provided instead of a macro scan deflector, such as an electrostatic scan deflector (not shown). A scan-deflector array 260 may be more spatially compact than a macro scan deflector.

The objective lens array assembly may comprise a detector 240. (Alternatively the detector maybe comprised in the charged particle device 41 without having to be present in the objective lens array assembly). The detector 240 may comprise detector elements 405 (e.g. sensor elements such as capture electrodes). The detector 240 may comprise any appropriate type of detector. For example, the detector elements may be charged based detector configured to detect charge detected with respect to time e.g. as current, scintillators or using semiconductor devices such as PIN elements. The detector 240 may be a direct current detector or an indirect current detector.

The detector 240 may be positioned between the objective lens array 241 and the sample 208. The detector 240 is configured to be the most down-beam feature of the electron-optical device, for example proximate the sample 208. The detector 240 may be very close to the sample 208, for example less than 5mm, 3mm, 1.5 mm, 300 µm, preferably between 200 and 10 µm, more preferably between 100 and 30 µm, for example less than or equal to approximately fifty µm.

The detector 240 may be positioned in the device so as to face the sample 208. Alternatively or additionally, the detector 240 may be positioned elsewhere in the electron-optical system 41 such that part of the electron-optical device that faces the sample 208 is other than, and thus is not, a detector; such as an electrode of the objective lens arrangement In such an arrangement another element of the electron-optical device may face the sample during operation, for example an electrode plate of the objective lens. In all these arrangements there is a most downbeam element of the electron-optical system, such as detector 240, most proximate to the sample. The most downbeam surface of the most downbeam element may face the sample. The most downbeam surface may be referred to as a facing surface.

A bottom surface of the detector 240 (or a facing surface of the detector 240 which may face a sample 208 in use, may comprise a substrate 404 on which are provided a plurality of detector elements 405. Each detector element 405 may surround a beam aperture 406. The beam apertures 406 may be formed by etching through the substrate 404. In the arrangement the beam apertures 406 are in a hexagonal close packed array, or alternatively in a rectangular array. The detector elements 405 may be arranged in a rectangular array or a hexagonal array.

In cross section of the detector, the detector elements 405 form the bottommost, i.e. most close to the sample 208, surface of the detector 240. Between the detector elements 405 and the main body of the substrate 404 a logic layer 407 may be provided. At least part of the signal processing system may be incorporated into the logic layer 407. A wiring layer 408 is provided on the backside of, or within, the substrate 404 and connected to the logic layer 407 by through-substrate vias 409. The wiring layer 408 can include control lines, data lines and power lines. A printed circuit board and/or other semiconductor chips may be provided on, for example connected to, the backside of detector 240.

The detector 240 may be implemented by integrating a CMOS chip detector into an electrode of the objective lens array 241, such as the bottom electrode of the objective lens array 241. Integration of a detector 240 into the objective lens array 241 or other component of the electron-optical system 41 allows for the detection of electrons emitted in relation to multiple respective sub-beams. The CMOS chip may embody the detector it may be orientated to face the sample. In an embodiment, detector elements 405 to capture the secondary charged particles are formed in the surface metal layer of the CMOS device. The detector elements 405 can be formed in other layers. Power and control signals of the CMOS may be connected to the CMOS by the through-silicon vias. A passive silicon substrate with holes shields the CMOS chip from high E-fields, for example providing robustness.

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to an array pitch (i.e. of the pitch of the apertures of the aperture array in the electrodes of the objective lens assembly 241). The diameter of each detector element may be less than approximately 600 µm, and preferably between approximately 50 µm and 500 µm. The pitch may be selected depending on the intended distance between the sample 208 and the detector 240. In an embodiment the outer shape of the detector element 405 is a circle, but this can be made a square to maximize the detection area. The diameter of the through-substrate via 409 can be minimized. A typical size of the electron beam is in the order of 5 to 15 µm.

In an embodiment, a single detector element 405 surrounds each beam aperture 406. In another embodiment, a plurality of detector elements 405 are provided around each beam aperture 406.

In other embodiments, for example variations of the arrangements shown in and described with reference to **FIG. 4****,** both the macro scan deflector 265 and the scan-deflector array 260 are provided. In such an arrangement, the scanning of the sub-beams over the sample surface may be achieved by controlling the macro scan deflector and the scan-deflector array 260 together, preferably in synchronization.

The provision of a scan-deflector array 260 instead of a macro scan deflector can reduce aberrations from the control lenses. This is because the scanning action of the macro scan deflector causes a corresponding movement of beams over a beam shaping limiter (also referred to as a lower beam limiter) defining an array of beam-limiting apertures down-beam of at least one electrode of the control lenses, which increases a contribution to aberration from the control lenses. When a scan-deflector array 260 is used instead the beams are moved by a much smaller amount over the beam shaping limiter. This is because the distance from the scan-deflector array 260 to the beam shaping limiter is much shorter. Because of this it is preferable to position the scan-deflector array 260 as close as possible to the objective lens array 241 (e.g. such that the scan-deflector array 260 is directly adjacent to the objective lens array 241 as depicted in **FIG. 4****.** The smaller movement over the beam shaping limiter results in a smaller part of each control lens being used. The control lenses thus have a smaller aberration contribution. To minimize, or at least reduce, the aberrations contributed by the control lenses the beam shaping limiter is used to shape beams down beam from at least one electrode of the control lenses. This differs architecturally from conventional systems in which a beam shaping limiter is provided only as an aperture array that is part of or associated with a first manipulator array in the beam path and commonly generates the multi-beams from a single beam from a source. In. In an arrangement, the beam shaping limiter 262 is structurally integrated with an electrode of the objective lens array 241. Desirably, the beam shaping limiter 262 is positioned in a region of low electrostatic field strength. Each of the beam-limiting apertures of the beam shaping limiter 262 is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping limiter 262 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In some embodiments, as exemplified in **FIG. 4****,** the control lens array 250 is the first deflecting or lensing electron-optical array element in the beam path down-beam of the source 201.

In the embodiment of **FIG. 4****,** a collimator element array 271 is provided instead of a macro collimator, which may be an electrostatic collimator of two or more plates having single apertures (which may be in the form of a macro collimating lens, for example as an electrostatic lens). The collimator element array 271 may be more spatially compact than a macro collimator 270. Providing the collimator element array 271 and the scan-deflector array 260 together may therefore provide space saving. This space saving is desirable where a plurality of the electron-optical systems comprising the objective lens array assembly are provided in an electron-optical system array. In such an embodiment there may be no macro condenser lens or a condenser lens array. In this scenario the control lens therefore provides the possibility to optimize the beam opening angle and magnification for changes in landing energy.

In some embodiments, as exemplified in **FIG. 4****,** the collimator element array 271 is the first deflecting or focusing electron-optical array element in the beam path down-beam of the source 201.

Avoiding any deflecting or lensing electron-optical array elements (e.g. lens arrays or deflector arrays) up-beam of the control lens array 250 or up-beam of the collimator element array 271 reduced requirements for electron-optics up-beam of the objective lenses, and for correctors to correct for imperfections in such optics. For example, some alternative arrangements seek to maximize source current utilization by providing a condenser lens array in addition to an objective lens array. The provision of a condenser lens array and an objective lens array in this manner results in stringent requirements on position of the virtual source position uniformity over the source opening angle, or requires corrective optics per sub-beam in order to make sure each sub-beam passes through the center of its corresponding objective lens down-beam. Architectures such as that of **FIG. 4** allow the beam path from the first deflecting or lensing electron-optical array element to a beam shaping limiter to be reduced to less than about 10mm, preferably to less than about 5mm, preferably to less than about 2mm. Reducing the beam path reduces or removes the stringent requirements on virtual source position over the source opening angle.

In an embodiment, an electron-optical system array is provided. The array may comprise a plurality of any of the electron-optical systems described herein. Each of the electron-optical systems focuses respective multi-beams simultaneously onto different regions of the same sample. Each electron-optical system may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical systems in the array may be arranged adjacent to each other so as to project the respective multi-beams onto adjacent regions of the sample 208. Any number of electron-optical systems may be used in the array. Preferably, the number of electron-optical systems is in the range of from 9 to 200. In an embodiment, the electron-optical systems are arranged in a rectangular array or in a hexagonal array. In other embodiments, the electron-optical systems are provided in an irregular array or in a regular array having a geometry other than rectangular or hexagonal. Each electron-optical system in the array may be configured in any of the ways described herein when referring to a single electron-optical system. As mentioned above, the scan-deflector array 260 and collimator element array 271 are particularly well suited to incorporation into an electron-optical system array because of their spatial compactness, which facilitates positioning of the electron-optical systems close to each other.

In some embodiments, as exemplified in **FIG. 4****,** the objective lens array assembly which is a unit that comprises the objective lens array 241) further comprises a beam shaping limiter 242. The beam shaping limiter 262 defines an array of beam-limiting apertures. The beam shaping limiter 242 may be referred to as a lower beam shaping-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In some embodiments, the charged particle device 41, for example as shown in and described with reference to **FIG. 4****,** further comprises an upper beam limiter 252, for example in addition to the beam shaping limiter 242 . The upper beam limiter 252 defines an array of beam-limiting apertures. The upper beam limiter 252 may be referred to as an upper beam-limiting aperture array or upbeam beam-limiting aperture array. The upper beam limiter 252 may comprise a plate (which may be a plate-like body) having a plurality of apertures. The upper beam limiter 252 forms sub-beams from a beam of charged particles emitted by the source 201. Portions of the beam other than those contributing to forming the sub-beams may be blocked (e.g. absorbed) by the upper beam limiter 252 so as not to interfere with the sub-beams downbeam. Charged particles projected through apertures in the upper beam limiter 252 may from sub-beams. The upper beam limiter 252 may be referred to as a sub-beam defining aperture array.

Any of the objective lens array assemblies described herein may further comprise a detector 240 having any of the features as described. The detector detects electrons emitted from the sample 208. The detected electrons may include any of the electrons detected by an SEM, including secondary and/or backscattered electrons emitted from the sample 208.

**FIG. 5** schematically depicts a charged particle assessment system 40 according to an embodiment. Features that are the same as those described above are given the same reference numerals. For conciseness, such features are not described in detail with reference to **FIG. 5****.** For example, the source 201, the condenser lenses 231, the macro collimator 270, the objective lens array 241 and the sample 208 may be as described above.

As described above, in an embodiment the detector 240 is between the objective lens array 241 and the sample 208. The detector 240 may face the sample 208. Alternatively, as shown in **FIG. 5****,** in an embodiment the objective lens array 241, which comprises the plurality of objective lenses, is between the detector 240 and the sample 208. The detector 240 may have all the features of the earlier described embodiments for example with reference to **FIGs. 3** **and** **4****,** except as herein described.

In an embodiment a deflector array 95 is between the detector 240 and the objective lens array 241. In an embodiment the deflector array 95 comprises a Wien filter (or even a Wien filter array) so that deflector array may be referred to as a beam separator. The deflector array 95 is configured to provide a magnetic field to disentangle the charged particles projected to the sample 208 from the secondary electrons from the sample 208. However, it is preferable that the system comprises electrostatic components, rather than magnetic components.

In an embodiment the detector 240 is configured to detect signal particles by reference to the energy of the charged particle, i.e. dependent on a band gap. Such a detector may be a semiconductor based detector such as a PIN detector or a scintillator (which is optically connected to a photonic converter or photon to electron converter. Such a detector 240 may be called an indirect current detector. The secondary electrons emitted from the sample 208 gain energy from the fields between the electrodes. The secondary electrodes have sufficient energy once they reach the detector 240.

The control lens array 250 may be in the same module as an objective lens array 241, i.e. forming an objective lens array assembly or, in one type of terminology, as part of the objective lens array, or it may be in a separate module

In some embodiments for example of any of the embodiments described with reference to and shown in **FIGs 3****,** **4** **and** **5****,** one or more aberration correctors are provided that reduce one or more aberrations in the sub-beams. The one or more aberration correctors may be provided in any of the embodiments, e.g. as part of the charged particle-optical device, and/or as part of an optical lens array assembly, and/or as part of an assessment system, and/or as part of an electron-optical arrangement. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, the objective lens array 241. In an embodiment, these aberration correctors reduce one or more of the following: field curvature; focus error; and astigmatism. Additionally or alternatively, one or more scanning deflectors (not shown) may be integrated with, or directly adjacent to, the objective lens array 241 for scanning the sub-beams 211, 212, 213 over the sample 208. In an embodiment, the scanning deflectors described in US 2010/0276606, which document is hereby incorporated by reference in its entirety, may be used.

As shown in **FIG. 2** (when read in context of the charged particle devices 41 as depicted in and described with respect to **FIGs 3 to 5**), in an embodiment the projection assembly 60 optionally comprises an optical system 63. In an embodiment, the projection system 60 comprises a light source 61. The light source 61 is configured to emit the light beam 62. As mentioned above the projection assembly 60 is used to illuminate a light beam 62 on the sample 208 so as to control the accumulated charges due to effects such as photoconductivity, photoelectric, or thermal effects; and thus regulate the accumulated charges on the sample.

In an embodiment the optical system 63 comprises a cylindrical lens 64. The cylindrical lens 64 is configured to focus the light beam 62 more in one direction than in an orthogonal direction. The cylindrical lens increases the design freedom for the light source 61. In an embodiment the light source 61 is configured to emit a light beam 62 having a circular cross section.

It is not essential for a cylindrical lens 64 to be provided. In an alternative embodiment another optical component can be used that is capable of focusing more strongly in one direction than another. In an alternative embodiment, the light source is configured to emit a light beam 62 that is elliptical or rectangular, for example. This is desirable to ensure the light beam reaches a portion of the sample required to be illuminated despite the small dimension between the sample and the most downbeam surface of the charged particle device 41 and the large dimension of the downbeam surface of the electron-optical device orthogonal to the orientation of the beam path.

In an embodiment the optical system 63 comprises reflecting surfaces 65, 66 such as mirrors. For example two reflecting surfaces 65, 66 may be provided. In an alternative embodiment, the optical system 63 does not reflect the light beam 62. The number and arrangement of the reflecting surfaces may be chosen depending on the dimensions of the volume in which the projection system 60 is required to fit. Such reflection surfaces may be desirable to improve the reach of the light beam 62 between the most downbeam surface of the charged particle device and the sample.

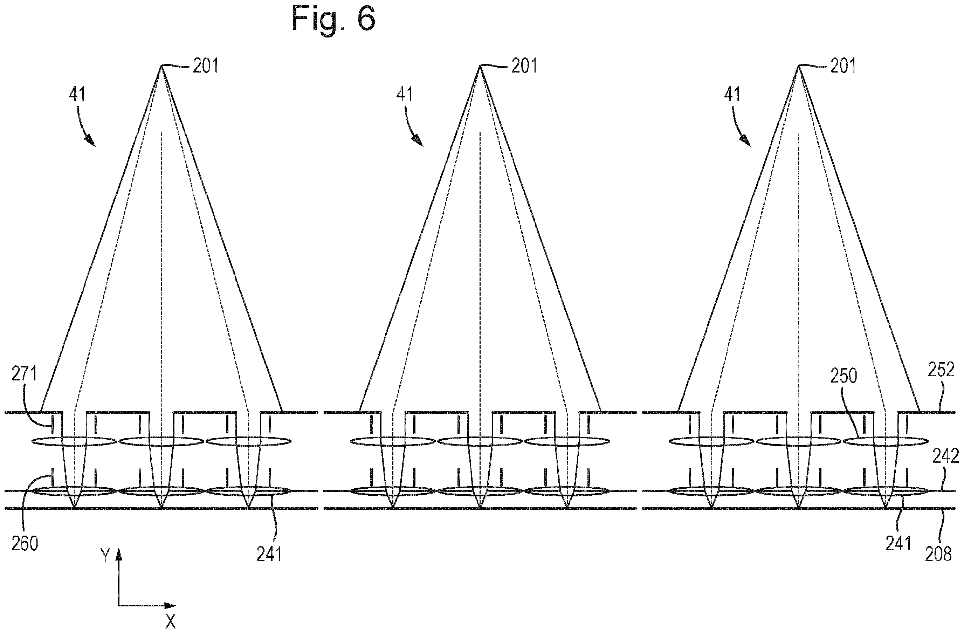

The invention herein disclosed may be applied to various different tool architectures. The charged charged particle apparatus comprises a plurality of columns of multi-beams. Each column may comprise a charged particle device, for example an charged particle device 41, described in any of the above embodiments or aspects. As a plurality of columns (or a multi-column apparatus) which comprises a plurality of devices (or a multi-device array), the devices may be arranged in an array which may number two to one hundred devices or more (or may be comprised in two to one-hundred columns). The charged particle apparatus may take the form of an embodiment as depicted in **FIG. 6****,** which is an apparatus comprising a plurality of the charged particle devices 41 as described above with reference to **FIG. 4****.** The charged particle apparatus preferably has an electrostatic scan deflector array and an electrostatic collimator array. A charged particle column may optionally comprise a source. Note in a different arrangement, the devices in the multi-device array may take any suitable design such as shown in and described with reference to FIGs. 3 or 5 (not shown).

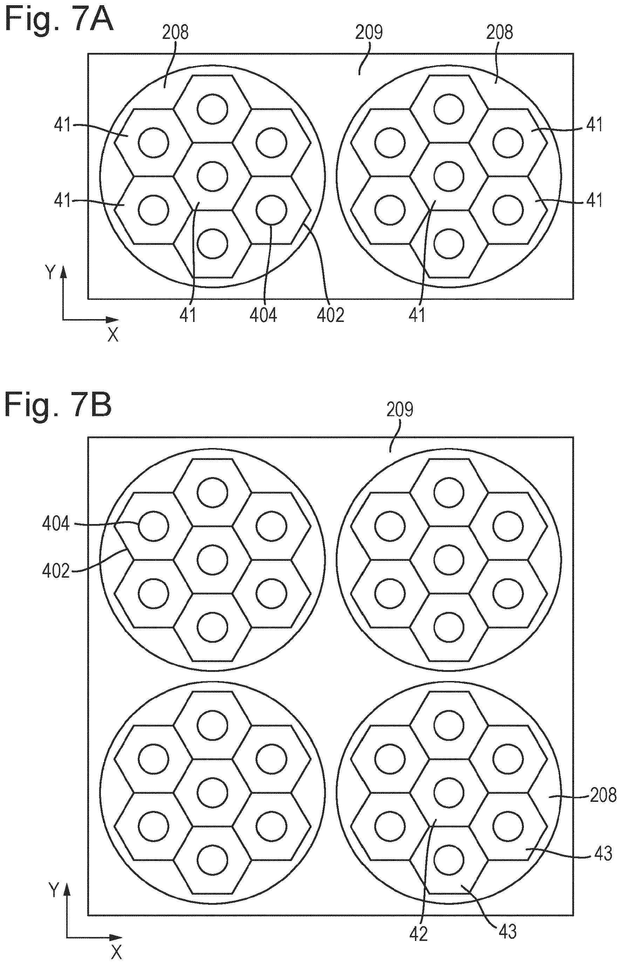

The facing surface of a charged particle device of the multi-device array comprises an active area and mechanical area. The active area comprises the surface of a charged particle optical component, such as a detector e.g. detector array desirably comprising an array of apertures for the beam grid, or a lens electrode such as a plate featuring an array of apertures for the path of the beam grid. In **FIGs 7A to 7C****,** the active area may be represented by a circle 404. The mechanical area may be a surface of a component to support and isolate one or more charged particle optical component such as the plate electrode or detector array. The component to support and isolate the charged particle component may be a spacer. In **FIGs 7A to 7C****,** the mechanical area may be represented by a hexagon 402 around the circular representation of the surface of the charged particle optical component. The outline of hexagonal represents the radial extent of the facing surface charged particle device relative to the direction of the path of the beam grid, for example separating two charged particle devices, and the exterior of the set of charged particle devices or multi-device array (for most outward situated charged particle devices relative to the respective set and/or multi-device array. The outline need not be hexagonal but any suitable shape such as rectilinear, rectangular, squire or rhombic, as defined by the geometrical arrangement of the charged particle devices with a respective set of the charged particle devise and optionally the multi-device array.

**FIGS. 7A-C** provides a plan views of three different arrangements of charged particle apparatus for projecting multiple beam grids of charged particle beams towards a plurality of samples. Such a grid may comprise a plurality of charged particle beams, for example which may be derived from a common source beam (i.e. a single source). The apparatus of **FIG. 7A** comprises a stage 209 and a plurality of charged particle devices 41 arranged in an array. The stage 209 is configured to support a plurality of samples 208 at respective sample positions, for example two sample positions i.e. for two samples 208. Such a sample may supported its sample position by a sample holder 207. Note reference herein to a sample position is intended to refer to support of a sample by a sampler holder. The stage may comprises a plurality of sample holders, for example as many sample holders as samples. The charged particle devices 41 are respectively configured to project a plurality of charged particle beams in the beam grid towards the sample positions. In other words, each charged particle device 41 is configured to project a multiple beams of charged particles towards a sample 208 disposed at one of the respective sample positions on the stage 209. In an embodiment, it is noted a more effective arrangement of charged particle devices may be achieved without a projection assembly 60 for each device. Such an arrangement may permit a more compact arrangement of the devices for example for a design when the projection assembly my conflict with the volume required for an adjoining charged particle device.

In one arrangement, the stage 209 is configured to be actuated relative to the array of charged particle devices 41. The stage 209 and the array of charged particle devices 41 are configured such that the array of charged particle devices scan relative to the plurality of samples 208 simultaneously. The stage 209 and the array of charged particle devices 41 may be configured so that at least one of the plurality of sample positions (e.g. comprising sample holders 207) is configured to be actuated relative to at least one of the charged particle devices 41. Alternatively, or additionally, the array of charged particle devices 41 may be configured to be actuated relative to the stage 209 so that the array of charged particle devices 41 scan relative to the plurality of samples.

In another arrangement, the stage 209 is configured to actuate the sample positions (e.g. sample holders 207) with respect to the array of charged particle optical devices 41. In particular, the stage 209 and array of charged particle devices 41 may be configured so that at least one of the plurality of sample positions is configured to be actuated relative to at least one of the array of charged particle devices 41. In this way at least one of the charged particle optical devices 41 and the plurality of sample positions may be scanned relative to each other. In particular, the stage 209 and array of charged particle devices 41 may be configured so that stage and the array of charged particle optical devices are actuatable relative to each other. The stage 209 and the array of charged particle-optical devices 41 are optionally configured so that the array of devices 41 scan relative to the plurality of sample positions simultaneously.

In the apparatus of any of these arrangements, there are a plurality of sample positions on the same stage and samples disposed at each of the sample positions may be scanned simultaneously. As such, the throughput of samples being processed, for example assessed, by the apparatus is increased compared to apparatus configured to scan only one sample at a time. For example, each charged particle device may be for sample assessment. The apparatus may be able to assess more samples per hour due to the one apparatus, or machine, being configured to support and assess a plurality of samples simultaneously. This would save cost and space, for example apparatus footprint e.g. in a chip fabrication facility, compared to requiring multiple completely separate machines each assessing (e.g. measuring or inspecting) only one sample at a time. In particular, with the present arrangement some components may be shared between multiple samples in the same machine/apparatus.

The charged particle apparatus may comprise, for example a vacuum chamber. The stage may be disposed within the vacuum chamber. With the present arrangement, there are multiple sample positions on the stage and thus multiple samples may be assessed simultaneously using only one vacuum chamber. Conversely, if it is desired to simultaneously assess multiple samples using apparatus/machines having a stage configured to support only a single sample then multiple apparatus/machines would be needed meaning multiple separate vacuum chambers would need to be provided and maintained. As such, the present arrangement may reduce installation, running and maintenance cost without having a detrimental impact on throughput of samples.

The charged particle devices 41 may correspond to the charged particle device described with respect to **FIG. 4** and **FIG. 6****.** However, alternative charged particle devices, for example as described above with reference to **FIG. 3** and **FIG. 5****.** In particular, each of the charged particle devices comprise an objective lens and a detector. The objective lens is configured to direct the beam grid of the charged particle device on a sample at the respective sample position. The detector is configured to detect signal particles from the sample. In an embodiment the detector may provide a facing surface of the different charged particle optical devices for facing a sample during operation, or a surface of an electrode of an objective lens. (Note reference to the objective lens and detector may be considered reference to an objective lens array and detector array, respectively).

The objective lens is desirably electrostatic. It is desirable that the charged particle optical components of each charged particle device are electrostatic rather than magnetic. If magnetic components are used, the charged particle devices may need to be spaced apart from each other sufficiently, by a distance which reduces the risk of magnetic interference between charged particle devices. Thus the use of electrostatic components may be more desirable, in enabling the charged particle devices in the array to be more closely grouped. This may increase the number of charged particle devices which may simultaneously project charged particle beams to a single sample. In turn, the greater number of charged particle devices dedicated to each sample may further aid in increasing throughput of samples processed on the apparatus.

The array of charged particle devices may comprise a plurality of sets of charged particle devices, each set comprising a plurality of charged particle devices. The sets of charged particle devices are configured to project a plurality of charged particle beams in a beam grid towards the respective the sample positions. In other words, each set of charged particle devices may be arranged such that the charged particle devices in that set are configured to project charged particle beams towards a particular sample position among the plurality of sample positions.

In the arrangements of **FIG. 7A and 7B****,** adjoining sets of charged particle device are spaced apart from each other. The arrangement shown in **FIG. 7A** differs from the arrangement shown **FIG. 7B** in having a two dimensional array of sample positions and a two dimensional array of sets of charged particle devices, rather than the plurality of sample positions and sets of charged particle devise being arranged in a linear array (as shown in **FIG. 7B****).** For example (and as depicted), the arrangement of **FIG. 7A** has two sample positions and two corresponding sets of charged particle devices; whereas the arrangement shown in **FIG. 7B** has four sample positions and two corresponding sets of charged particle devices. With the arrangements of **FIG. 7A and 7B****,** there may be a benefit that space between the sets of charged particle devices may be used to store supporting electronics and architecture of the set of charged particle devices. This use of space may provide easier access for servicing. With the arrangements of **FIG. 7A and 7B****,** each set of charged particle devices may be assigned to a different sample position. The number of sets of charged particle devices is therefore desirably equal to the number of sample positions.

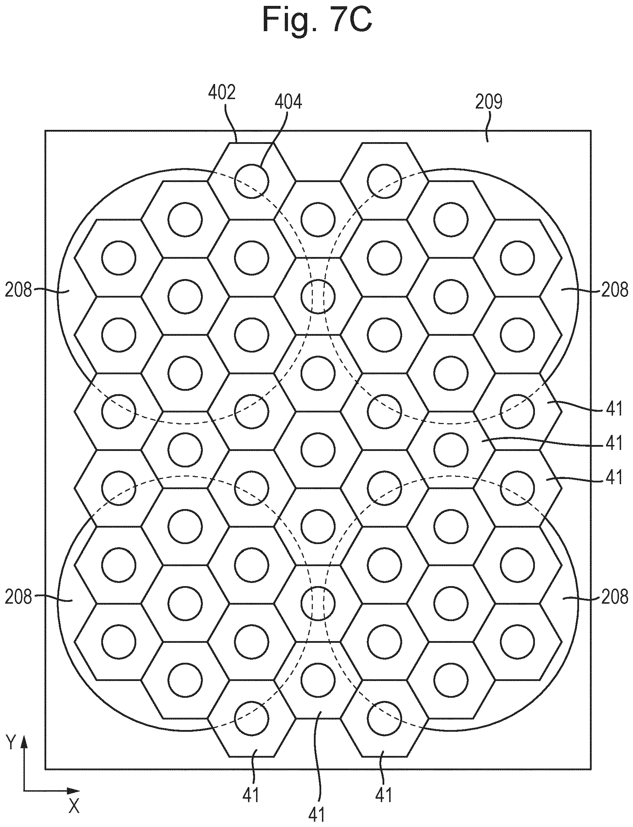

In the arrangements of **FIG. 7C****,** adjoining sets of charged particle device are not spaced apart from each other. Instead, with the arrangement of **FIG. 7C** the sets of charged particle devices are adjacent each other such that there is a single array of charged particle devices which is continuous between the different sets. That is the charged particle devices are arranged in a continuous two dimensional array or a continuous array (e.g. a continuous multi-device array). The continuous array may have a facing surfaces configured to face the stage, so that some devices face a sample position of the stage, and other devices face positions between or towards the periphery of the stage away from a sample position. With the arrangement of **FIG. 7C** there may be the benefit that not all of the charged particle devices may be assigned, or dedicated, to only one particular sample position. Instead, there may be charged particle devices which are configured to project charged particle beams towards a plurality of different sample positions, at respective times.

In any of the arrangements of **FIG. 7A-C** the sets of charged particle devices are each configured to face towards a respective sample position, or at least a range of positions of a sample position that the sample position and set of charged particle devices may have during scanning. Each set of charged particle devices may be configured to project a plurality of beam grids towards a corresponding sample position, or at least part of the range of positions of the sample position that the sample position may have during scanning. For example, at some sample positions a charged particle device may appear to be between sample positions in the embodiment shown and described with reference to **FIG. 7C****.** The sample positions may each have a corresponding origin position. The origin position may be a central position of the range of positions of the sample position. The sample positions may be configured to deviate from the origin position during scanning by a maximum distance equal to one pitch of one charged particle device of the respective set of charged particle devices facing the sample position. A plurality of charged particle devices may be configured to face the range of positions of the sample position during scanning. For example, a central charged particle device may be a central charged particle device which faces the sample position at the origin position of the sample position. Another charged particle device facing the sample position may be a charge particle device that is offset from the central charged particle device by a distance at least equal to the pitch between adjacent charged particle devices in the set of charged particle devices. Different beam grids of the of set of the charged particle devices may correspond to the different charged particle devices of the set of charged particle devices.

In the arrangements of **FIG. 7A and 7B****,** the number of charged particle devices in each set of charged particle devices is 7. In other arrangements, number of charged particle devices in each set of charged particle devices may be between 2 and 100, desirably in an embodiment between 7 and 37, more desirably between 7 and 19. It is desirable to have more charged particle devices in each set such that more devices may be dedicated to simultaneously scanning the same sample. This has the benefit that the sample will be scanned more quickly, increasing sample throughput. However, there is limited space available over each sample, which may be a circular disk having a 300 mm diameter. As such, the number of charged particles which may simultaneously project charged particle beams towards the same sample may be limited by space constraints due to the size of each charged particle device and its supporting electronics and structure.

As shown in **FIGS. 7A-C,** in an arrangement, the charged particle devices of each set have a hexagonal arrangement. However the charged particle devise may be arranged with a rectilinear, rectangular, square, rhombic or any other suitable geometric arrangement. For example, the array of charged particle devices may comprise two or more lines of charged particle devices, where the lines are arranged in a plane across a path of the beam grid of at least one the charged particle devices. The lines may comprise at least three charged particle devices. Desirably, the two or more lines of charged particle devices being parallel to each other. Alternatively, the two or more lines of charged particle devices may be lines of charged particle devices of the array that have different directions. The hexagonal arrangement may be preferred because it enables an optimally close packing of the charged particle devise within the arrangement. Thus the charged particle devices are arranged in a continuous two dimensional array. In the array of charged particle devices, a device is surrounded by at least four devices, for example six devices, positioned away in different directions. For example the two dimensional array is at least a three-by-three array in at least two directions of the array that are angled relative to each other.

In arrangements such as those illustrated in **FIGS. 7A-C,** in each set of charged particle devices 41, one of the charged particle optical devices, which may be referred to as a reference device 42 e.g. a central charged particle device 42 is surrounded in a plane across the beam grid path of at least one of the charged particle optical devices 41, by other charged particle devices 43 of the set of charged particle optical devices 41.

In particular, in the arrangements of **FIGS 7A and 7B****,** each set comprises a central charged particle device 42 disposed at the center of the set, and a plurality of other charged particle devices 43. The other charged particle devices 43 are disposed around the central charged particle device 42 to form a ring of charged particle devices. (Where more charged particle devices may be located around the other charged particle devices 43, the ring of other charged particle devices 43 may be referred to as an inner ring of charged particle devices). However, there may be fewer than six charged optical devices in the ring of charges optical devices. There are desirably at least four charged particle devices in the ring, with each of the charged particle devices of the ring being located in different positions in a plane across the charged particle devices, for example across the paths of the charged particle beams in the beam grids, for example orthogonal to the paths of the beam grids (e.g., the X-Y plane) relative to the central charged particle device. The charged particle devices of the ring may be positioned to be in different directions in the plane across the paths of the beam grids relative to the path of the beam grid (or charged particle axis) of the central charged particle device. Four of the charged particle devices of the ring may be located in different directions, i.e. four different directions from the charged particle axis of the central charged particle device. Desirably the four different directions comprise at least one pair of directions that oppose each other. In arrangement, the four different directions comprise two pairs of directions that oppose each other. Each pair of directions that oppose each other has a common direction. There may be two common directions which may be orthogonal to each other.

Optionally, a further ring of additional charged particle devices may be disposed around the inner ring, to form an outer ring of charged particle devices for example relative to the inner ring. The inner ring of charged particle devices 43 are adjacent to the central charged particle device 42. The optional outer ring of charged particle devices may be adjacent to the inner ring of charged particle devices. In being adjacent the inner ring, the further ring of charged particle devices may be arranged compactly desirably minimizing volume use with the multi-device array having additional charged particle devices. Yet further rings of charged particle devices may surround the inner ring and the further rings (i.e. rings of charged particle devices between the yet further rings and the central charged particle device of the set of charged particle devices). The ring of charged particle devices with a device furthest from the central charged particle device, or from the center of the sample position, may be referred to as the outermost ring of charged particle devices for example within a set of the charged particle devices. The arrangement of a central charged particle device surrounded by one or more rings of further charged particle devices enables the charged particle devices to be compactly arranged within a set of charged particle devices within the multi- device arrangement. Such a set of charged particle devices can be compactly arranged desirably to optimise, for example maximise, the number of charged particle devices in a facing surface of a set of charged particle devices facing the corresponding sample position. That is the arrangement of charged particle devices within the multi-device array is designed to make efficient use of the space facing the sample (i.e. the facing surface facing the sample position).

One or more of the sets of charged particle devices may configured to be actuated in at least one degree of freedom relative to the stage and/or each other. Desirably all of the sets of charged particle devices are configured to be actuated. The sets of charged particle devices are desirably configured to be actuated in a direction along the beam grid of at least one of the charged particle optical devices of the array of charged particle optical devices, desirably the respective set of charged particle-optical devices. The direction along the beam grid may be perpendicular to a major surface of a sample, when the sample is disposed at the respective sample position.

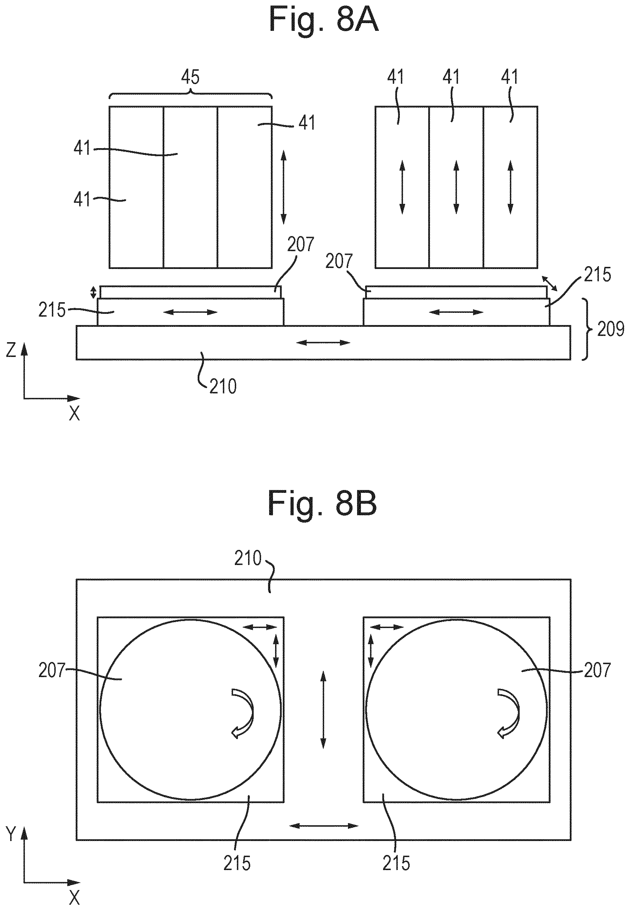

**FIG. 8A** provides a side view of an exemplary stage 209, two sample supports 207 and two sets 45 of charged particle devices 41. The stage 209 comprises a coarse actuator 210 and two sub-stages 215. **FIG. 8B** provides a plan view of the stage 209 and sample supports 207 of **FIG. 8A****.** As shown in **FIG. 8A****,** each of the sets 45 of charged particle devices 41 is configured to be actuated in at least the Z-direction. The Z-direction may be perpendicular to the scanning and sub-scanning directions (each being one of the X- and Y-directions respectively) of the stage 209 of **FIGS. 8A and 8B****.** Although an arrangement is shown with two sample positions and two sets of charged particle devices, the description may apply to an arrangement of any number of sample positions and the same number of sets of charged particle devices, or a continuous arrangement of charged particle devise.

To facilitate actuation of the stage and the sets 45 of charged particle devices 41 relative to each other. Each set 45 may comprise an actuator arrangement configured to actuate the set of charged particle optical devices within the array of charged particle optical devices. Alternatively, or additionally, the charged particle devices of the different sets of charged particle devices may comprise electron-optical elements which are configured to operate on the charged particle beams of the respective beam grid so as to actuate the respective set of charged particle devices relative to other set of charged particle devices and/or the respective sample position.

It is desirable that each set of charged particle devices is configured to be actuated in at least one degree of freedom. Each set of charged particle devices is optionally configured to be actuated in up to six degrees of freedom. The ability to actuate each set in at least the direction of a charged particle beam of a charged particle device of that same set may aid in sample processing. In particular, actuation of the sets may enable the set to be positioned optimally with respect to a sample disposed at the respective sample position. It is desirable that each set is configured to be individually actuated in order to be positioned facing, for example over, its respective sample. The charged particle beams are thus directed and focused on the sample.

Additionally or alternatively, one or more, and desirably all, of the charged particle devices 41 of the array may be configured to be individually actuated in at least one degree of freedom. Desirably to be individually actuated in a direction along the beam grid path of the charged particle optical device desirably perpendicular to a major surface of a sample at the corresponding sample position, desirably to a plane of the major surface. Such a major surface of a sample may be the facing surface of a sample facing one or more charged particle devices. For example, in the arrangement shown in **FIG. 8A****,** each of the charged particle devices 41 is configured to be actuated in at least the Z-direction. The Z-direction may be perpendicular to the scanning and sub-scanning directions (X- and Y-directions) of the stage 209 of **FIGS. 8A and 8B****,** for example substantially parallel to one more beam grids of a set of the charged particle devices 41.

To facilitate actuation, the charged particle apparatus mat comprise a plurality of actuators. One of the plurality of actuators may be associated with each charged particle device. Each actuator is desirably configured to actuate the corresponding charged particle device relative to another charged particle device and/or the sample position for example in the one more degrees freedom, for example orthogonal to a plane a sample position, around a direction orthogonal to a plane of a sample position, (e.g. rotation) and/or tilt for example rotation along a direction in the plane of the sample position..

Alternatively, or additionally, the charged particle devices may respectively comprise one or more electron-optical elements configured to operate on the beams of the beam grid of the charged particle optical device. The one or more electron-optical elements may be configured to operate on the beam grid to actuate the beams of the beam grid, such as one or more electrode plates of an objection lens array, such as of a control lens array. The beams of the beam grid may be actuated relative to the respective sample position and/or the beam grid of other charged particle optical devices of the array of charged particle optical devices and/or the set of charged particle optical devices to which the respective charged particle optical device belongs.

It is desirable that each charged particle device is configured to be actuated in at least one degree of freedom. Each charged particle device is optionally configured to be actuated in up to six degrees of freedom. The ability to actuate each charged particle device in at least the direction of a charged particle beam of a charged particle device of that same set may aid in sample processing. In particular, actuation of the charged particle devices may enable the charged particle devices to be positioned optimally with respect to a sample disposed at the respective sample position. It is desirable that each charged particle device is configured to be individually actuated in order to be positioned proximate, for example over, its respective sample such that the charged particle beams are properly directed and focused on the sample. However, the ability to actuate each charged particle device individually may add to the complexity of the apparatus. As such, it may be preferable that the sets of charged particle devices may be actuated; but that each charged particle device may not be individually actuated. Thus, groups of charged particle devices, such as the set of charged particle devices may be actuated; thus the charged particle devices may be actuated in groups of the multi-charged particle device. Alternatively, or additionally, it may be advantageous to actuate the sample relative to the charged particle devices. Additional or alternatively, the stage may have an actuator to actuate one or more of the sample positions relative to the sets of charged particle devices.

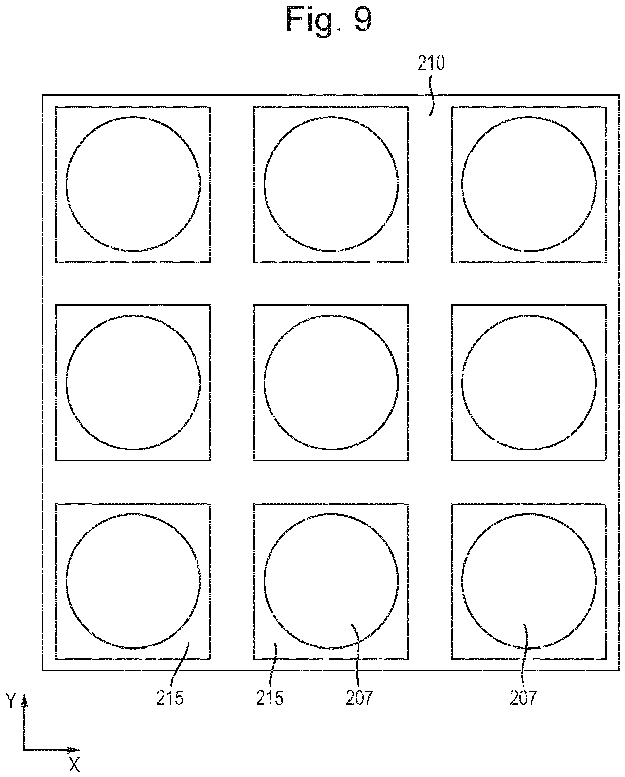

The stages shown in **FIG. 7A****,** **FIG. 8A and 8B** each provide two sample positions arranged in a plane, in particular the X-Y plane. However, in alternative arrangements there may be more than two sample positions on the stage. The stage may provide four sample positions, for example as shown in **FIGS. 7B** **and** **7C****.** There may be between 2 and 20 sample positions, preferably between 2 and 9, more preferably between 5 and 9. **FIG. 9** provides a plan view of a stage 209 and sample supports 207. The arrangement depicted in FIG. 9 is the same as that of FIG. 8B except that where the arrangement of **FIG. 8B** comprised two sample positions, provided on corresponding sample supports 207, the arrangement of **FIG. 9** comprises 9 sample positions on the 9 sample supports 207.

The stage may comprise at least 5 sample positions, and desirably comprises 9 sample positions, for example as shown in **FIG. 9****.** The sample positions may be arranged in a plane and may include a central sample position that is surrounded by sample positions, desirably in four directions of the plane. As shown for example in **FIG. 9****,** the four directions may comprise at least one pair of directions that oppose each other, for example the X and/or Y direction of **FIG. 9****;** alternatively the four directions are the two pairs of sample positions placed opposing directions from a central sample position . With arrangements such as this, a relatively large number of samples may be provided on the same stage, which may improve throughput of samples, the rate of processing such as assessment, of sample surface area. Further by having as many as nine sample positions on the same stage, the apparatus footprint may be considerably smaller than the total footprint of nine different apparatus.

The stage 209 and/or sample supports 207, also referred to as sample holders, may be configured to support the respective samples. The stage may actuate the sample positions in order to actuate a sample disposed at the sample positions. At least one of the sample positions may be configured to be actuated in at least one degree of freedom, and desirably in three to six degrees of freedom, for example at least three of: in the plane of the sample positions, for example X and Y directions; around the direction of the path of the beam grid, e.g. an Rz direction; in a direction orthogonal to the plane of the same position e.g. in a z direction, and angled or tilted relative to the sample position, for example Rx and Ry.

In the arrangements of **FIG. 8A, 8B** **and** **9****,** the stage 209 comprises a coarse actuator 210. The coarse actuator is configured to actuate the plurality of samples. As shown in **FIGS. 8A and 8B****,** the coarse actuator 210 may be configured to actuate in at least one translational degree of freedom, and preferably in three translational degrees of freedom (X-, Y- and/or Z-direction). Desirably to in a direction (X- and/or Y-direction) in a plane across, desirably perpendicular to, the path of a beam grid of a device of the array of devices. The coarse actuator may optionally actuate all the sample positions by tilting the stage relative the direction of the beam grid of the array of charged particle devices, for example in rotation about the X-direction (Rx) and/or rotation about the Y-direction (Ry). In this way, the coarse actuator may actuate the samples in a scanning direction and/or a sub-scanning direction.

The coarse actuator is desirably configured to actuate at least one of the sample positions to alter the relative position of beams of the beam grids between different positions on the sample surface of the sample at the sample position. The different positions corresponding to different instances of repeated patterns of the sample.

In the depicted arrangements, the coarse actuator is configured to actuate all of the plurality of samples collectively. In an alternative arrangement, the coarse actuator may be configured to actuate more than one of the plurality of sample positions, but not all of the plurality of sample positions.

The charged particle apparatus of **FIG. 8A, 8B** **and** **9** comprise a plurality of sample supports 207, also referred to as sample holders. Each sample support is configured to support a sample at one of the respective sample positions.

In an arrangement, as shown in **FIG. 9****,** the sample supports 207 are arranged in a sample support array of a two dimensional array on the stage 209. In the sample support array shown in **FIG. 9****,** one of the sample supports 207 of the sample support array is surrounded by other sample supports 207 of the sample support array.

The sample support array may be formed in alternative arrangements to that of **FIG. 9****.** The sample support array desirably comprises sample supports 207 for two or more lines of sample positions. The lines of sample supports 207 may comprise two more adjoining sample supports, for example arranged in a linear array. The lines of sample positions each desirably comprising at least three adjacent sample positions. One or more of the lines of sample positions may be in a direction of, and extend, across the stage. The two or more lines of sample supports being different lines of sample supports in the sample support array. The sample support array having two or more lines of sample support; the two more lines of sample supports having different directions in the sample support array.

The sample supports 207 of the sample support array are desirably arranged, for example having a planar supporting surface, across a beam grid path of at least one of the charged particle optical devices of the array of charged particle optical devices. The sample support array is desirably in a plane (e.g. the X-Y plane of FIG. 9) across, and desirably that is orthogonal to, the beam grid path of at least one of the charged particle optical devices of the array of charged particle optical devices.

The sample supports are each configured to be actuated in at least one degree of freedom, and desirably between three and six degrees of freedom. The sample supports 207 are configured to be actuated relative to the charged particle devices 41, as shown in **FIG. 8A, 8B** **and** **9****.**

The sample supports may be configured to be actuated in at least one rotational degree of freedom. Desirably the sample supports are configured to be rotated around a direction through, desirably perpendicular to, a plane of a major surface of a sample at a sample position. Such a rotation motion may be around the Z-direction in **FIGS. 8A and 8B****.** In this way, the samples may be individually rotated for alignment prior to processing, such as assessment, using the charged particle beams of the charged particle devices. Such rotation of the sample about the direction of the path of the beam grid may be used to address relative rotational alignment between the different beam grids of the charged particle devices of the multi-device array. This may save time in the alignment of each of the plurality of samples to be simultaneously processed. As time is saved, the throughput of samples being processed per unit time, e.g. hour or day, may be increased as there is less set up time per sample than there would be in an apparatus without alignment adjustment via actuation of a sample support.

For similar reasons, such as in saving time and improving throughput, it is desirable for the sample supports 207 to be configured to be actuated individually, for example independently of actuation of another sample position, in a translational direction for example along the path of the beam grid of a charged particle device of the corresponding set of charged particle devices. Such a translation direction along the path of the beam grid may correspond to the Z-direction, as shown in **FIG. 8A****.** Independent actuation of the different sample positions along the direction of a path of a beam grid may adjust the relative focus positions of a sample at the sample position relative to facing electron-optical devices of the multi-device array.

Another translation direction may be in the plane orthogonal to the direction of a path of a beam grid. In **FIG 8B****,** this may be alone one or both of the X and Y axes. Such actuation of each sample position may actuate samples (when present) interpedently so they are moved parallel to the plane of the stage 209. Such movement may improve alignment of the sample with one or more of the charged particle devices 41 of the multi-device array, for example of the corresponding set 45 of charged particle devices 41. Such charged particle devices may be misaligned and such actuation may improve the average alignment of the charged particle devices: of the set of charged particle devices; and/or facing the sample position.

Alternatively, desirably additionally, the sample supports 207 may be configured to be actuated individually in one or two further rotational directions, which may be referred to as tilt with respect to a plane orthogonal to the direction of a path of a beam grid. In other words, as shown in **FIG. 8A****,** it is desirable that the sample positions are configured to be actuated in a rotational direction around the Y-direction (Ry). Similarly, it is desirable additionally, or alternatively, that the sample positions are configured to be actuated in a rotational direction around the X-direction (Rx). In this way, each sample may be tilted relative to the stage 209. This may improve alignment of the sample with charged particle devices 41 of the corresponding set 45 of charged particle devices 41.

If the apparatus is configured to actuate each sample in a sufficient number of degrees of freedom, then the complexity of having the sets of charged particle devices, or even each individual charged particle device also being configured to be actuated may be avoided. This may reduce the complexity of the system and therefore reduce the cost of construction, installation and maintenance.

As shown in **FIG 8A and 8B****,** the number of sets 45 of charged particle devices 41 is equal to the number of sample supports 207. With this arrangement, each set of charged particle optical devices 45 may be assigned to a different sample support 207. The charged particle devices 41 of each set are desirably configured to face towards a major surface of a sample supported at the respective sample position by a sample support. In this way the charged particle beams may be readily projected to each of a plurality of samples simultaneously.

The apparatus as shown in **FIG. 8A, 8B** **and** **9** further comprises a plurality of sub-stages, with each sub-stage being disposed at a corresponding sample position. Each of the sub-stages is configured to at least contribute to the actuation of one of the respective sample positions in at least one degree of freedom; for example in actuating the sample position in at least one of the degrees of freedom that the sample position is actuated relative to the coarse actuator 210. Each of the sub-stages may be configured to at least contribute to the actuation of one of the respective sample positions in in at least three degrees of freedom, desirably in six degrees of freedom. The sub-stages may be configured to actuate the sample positons in the same directions as the coarse actuator. The sub-stages may be configured to actuate the sample positons in a scanning direction and/or a sub-scanning direction. The range of actuation of the sub-stages may be smaller than the range of actuation of the coarse actuator. The actuation of the sub-stages may be achieved by one or more fine actuators, for example at least one fine actuator for each degree of freedom in which the fine actuators actuate the sample position. Such a fine actuator may be able to achieve finer actuation displacements of the sample position than a coarse actuator.

In the arrangements of **FIG. 8A, 8B** **and** **9****,** the sub-stages 215 are disposed on the coarse actuator 210. With this arrangement, the sub-stages 215 are supported by the coarse actuator; each of the sub-stages 215 is configured to actuate a corresponding sample position relative to the coarse actuator 210. In these arrangements, the stage 209 comprises the coarse actuator 210 and the sub-stages 215. The stage optionally further comprises the sample supports 207.

It is desirable that each sample position has a corresponding dedicated sub-stage. For example, as shown in **FIG.8A, 8B** **and** **9** each sample support 207 may be disposed on a different sub-stage 215. The sub-stage 215 is configured to actuate the sample support 207. The plurality of sub-stages may be configured to actuate at least two of the plurality of sample positions, and desirably all of the sample positions, independently of each other. With this arrangement, there may be improved control over the position and scanning of each sample individually.

In an alternative arrangement, one or more of the sub-stages may be configured to collectively actuate more than one sample position in at least one degree of freedom. For example, two adjacent sample positions may share the same sub-stage. Alternatively, in an arrangement without sub-stages, the sample positions may be provided on sample supports 207 disposed directly on the coarse actuator 210.

Each sub-stage may be configured to actuate a corresponding sample position relative to the path of a beam grid of at least one of the array of charged particle devices. Desirably, the sub-stage may activate the sample position relative to the path of a beam grid of at least one of the set of charged particle device assigned to the corresponding sample position. In particular, the sub-stage is desirably configured to actuate the sample position to alter the relative position of a sub-beam within a repeating patterned structure of the sample and/or a repeating patterned structure of a mark on the sub-stage e.g. on a sample holder, for example on a sensor mounted on the sub-stage or sample holder. The sub-stage may therefore provide more fine alignment of the sample than is provided by the coarse actuator. Thus for actuation directions in which the sample position is effectively actuated by the coarse actuator and the fine actuators of the sub-stages, the fine actuators may be controlled to fine tune the actuation of the coarse actuator for example in a specific degree of freedom.

### XXX CLAUSES XXX

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components to apply potentials to the components, such as in a non-limited list the control lens array 250, the objective lens array 241, the condenser lens 231, correctors, a collimator element array and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). For example, the aperture arrays, plate electrodes of for example the objective lens array, one more features of the detector array, scan-deflector array and collimator element array, may be formed using MEMS manufacturing techniques.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field.

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column 40 may be a component of an assessment system; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1. A charged particle apparatus for projecting multiple beam grids of charged particle beams towards a plurality of samples, the apparatus comprising: a stage configured to support a plurality of samples at respective sample positions; and an array of charged particle devices (for example a two dimensional array of devices), the charged particle devices being respectively configured to project a plurality of charged particle beams in a beam grid towards the respective the sample positions, the charged particle devices respectively comprising an objective lens and a detector, the objective lens being configured to direct the beam grid of the charged particle device on a sample at the respective sample position, and the detector being configured to detect signal particles from the sample, the stage being configured to be actuated relative to the array of charged particle devices, the stage and the array of charged particle devices being configured such that the array of charged particle devices scan relative to the plurality of samples simultaneously.
Clause 2. The charged particle apparatus of clause 1, wherein the stage and array of charged particle devices are configured so that at least one of the plurality of sample positions is configured to be actuated relative to at least one of the charged particle devices.
Clause 3. The charged particle apparatus of clause 1 or 2, wherein the array of charged particle devices are configured to be actuated relative to the stage so that the array of charged particle devices scan relative to the plurality of samples simultaneously.
Clause 4. The charged particle apparatus of any preceding clause, wherein the array of charged particle devices comprises a charged particle device that in a plane across a path of the beam grid of the device has two or more lines of at least three adjoining devices, the two or more lines being different lines of devices in the array, and the two or more lines having different directions in the array.
Clause 5. The charged particle apparatus of clause 4, wherein the array of charged particle devices comprises a charged particle device in a plane across a path of the beam grid of the device that is surrounded by adjoining devices, desirably in four different directions of the plane, desirably the four directions comprising at least one pair of directions that oppose each other.
Clause 6. The charged particle apparatus of any preceding clause, wherein the detector comprises a detector array.
Clause 7. The charged particle apparatus of any preceding clause, wherein the detector is disposed downbeam of the objective lens, desirably wherein the detector has a downbeam surface which is a facing surface of the charge particle device, desirably the facing surface facing one of the sample positions.
Clause 8. The charged particle apparatus of any preceding clause, wherein the array of charged particle device comprises a plurality of sets of charged particle device, wherein the sets of charged particle devices are configured to project a plurality of charged particle beams in a beam grid towards the respective the sample positions.
Clause 9. The charged particle apparatus of clause 8, wherein adjoining sets of charged particle device are spaced apart from each other.
Clause 10. The charged particle apparatus of clause 8 or 9, wherein the charged particle devices of each set have a hexagonal arrangement or rectilinear, desirably rectangular, arrangement.
Clause 11. The charged particle apparatus of any of clauses 8 to 10, wherein the number of charged particle devices in each set of charged particle devices is between 2 and 100, desirably between 7 and 37.
Clause 12. The charged particle apparatus of any of clauses 8 to 11, wherein in each set at least one of the charged particle optical devices is surrounded in a plane across the beam grid path of at least one of the charged particle optical devices, by others of the charged particle optical devices of the set.
Clause 13. The charged particle apparatus of any of clause 12, wherein each set comprises a central charged particle device desirably disposed at the centre of the set, and desirably a plurality of charged particle devices is disposed around the central charged particle device as at least one ring of charged particle devices, desirably the at least one ring of charged particle devices comprising an inner ring comprising charged particle optical devices that are adjacent to the central charged particle device.
Clause 14. The charged particle apparatus of clause 13, wherein the at least one ring of charged particle optical devices comprises a plurality of rings of charged particle devices, desirably disposed around the inner ring, desirably the a plurality of rings comprising an outer ring of charged particle devices that are adjacent to the inner ring of charged particle devices.
Clause 15. The charged particle apparatus of any of clauses 8 to 14, wherein the number of sets of charged particle devices is equal to the number of sample positions, desirably each set of charged particle devices is assigned to a different sample position.
Clause 16. The charged particle apparatus of clause 15, wherein each set of charged particle devices is configured to project a plurality of beam grids towards a corresponding sample position for a sample, desirably different beam grids of the of set of the charged particle devices corresponding to different charged particle devices of the set of charged particle devices.
Clause 17. The charged particle apparatus of any of clauses 15 or 16, further comprising a plurality of sample supports, wherein each sample support is configured to support a sample at one of the respective sample positions, wherein the number of sets is equal to the number of sample supports, desirably each set of charged particle optical devices is assigned to a different sample support.
Clause 18. The charged particle apparatus of any of clauses 8 to 17, wherein the of sets of charged particle-optical devise are each configured to face towards a respective sample position, desirably a major surface of a sample supported by a sample support desirably at the respective sample position.
Clause 19. The charged particle apparatus of any of clauses 8 to 18, wherein the sets of charged particle devices are each configured to be actuated in at least one degree of freedom relative to the stage and/or each other, desirably in a direction along the beam grid of at least one of the charged particle optical devices of the array of charged particle optical devices, desirably the respective set of charged particle-optical devices, desirably the direction along the beam grid is perpendicular a major surface of a sample, desirably to a plane of the major surface of the sample, at the respective sample position.
Clause 20. The charged particle apparatus of clause 19 wherein the sets of charged particle devices each comprise an actuator arrangement configured to actuate the set of charged particle optical devices relative to the stage and within the array of charged particle optical devices.
Clause 21. The charged particle apparatus of clause 19 or 20, wherein the charged particle devices of the different sets of charged particle devices comprise electron-optical elements which are configured to operate on the charged particle beams of the respective beam grid so as to actuate the respective set of charged particle devices relative to other set of charged particle devices and/or the respective sample position.
Clause 22. The charged particle apparatus of any preceding clause, wherein each charged particle device is configured to be individually actuated in at least one degree of freedom, desirably to be individually actuated in a direction along the beam grid path of the charged particle optical device desirably perpendicular to a major surface of a sample at the corresponding sample position, desirably to a plane of the major surface.
Clause 23. The charged particle apparatus of clause 22, wherein associated with each charged particle device is an actuator configured to actuate the charged particle device relative to another charged particle device and/or the sample position.
Clause 24. The charged particle apparatus of any preceding clause, wherein the charged particle devices respectively comprise one or more electron-optical elements configured to operate on the beams of the beam grid of the charged particle optical device, wherein the one or more electron-optical elements are configured to operate on the beam grid to actuate the beams of the beam grid relative to the respective sample position and/or the beam grid of other charged particle optical devices of the array of charged particle optical devices and/or the set of charged particle optical devices to which the respective charged particle optical device belongs.
Clause 25. The charged particle apparatus of any preceding clause, wherein at least the corresponding sample position is configured to actuate a sample in a rotational degree of freedom, desirably to rotate around a direction through, desirably perpendicular to, a plane of a major surface of a sample at a sample position, desirably relative to the path of a beam grid of at least one of the array of charged particle devices, desirably relative to the path of a beam grid of at least one of the set of charged particle devise assigned to the corresponding sample position.
Clause 26. The charged particle apparatus of any preceding clause, for example clause 25, wherein at least the corresponding sample position is configured to actuate a sample in at least one translational degree of freedom, desirably to actuate the sample in a direction through, desirably orthogonal to, a plane of a major surface of a sample at a sample position, and/or desirably to actuate the sample in a direction across the path of a beam grid of at least one of the charged particle devices directed towards the sample position, for example parallel to a plane of a major surface of a sample at a sample position, desirably relative to the path of a beam grid of at least one of the array of charged particle devices, desirably relative to the path of a beam grid of at least one of the set of charged particle devise assigned to the corresponding sample position.
Clause 27. The charged particle apparatus of clause 25 or 26, wherein the stage comprises at least one sub-stage configured to at least contribute to the actuation of at least one of the respective sample positions in at least one degree of freedom, desirably in at least three degrees of freedom, desirably in six degrees of freedom.
Clause 28. The charged particle apparatus of clause 27, wherein the at least one sub-stage is configured to actuate a corresponding one of the sample position in at least one degree of freedom relative to the path of a beam grid of at least one of the array of charged particle devices, desirably relative to the path of a beam grid of at least one of the set of charged particle devise assigned to the corresponding sample position.
Clause 29. The charged particle apparatus of clause 26 or 27, wherein the at least one sub-stage is configured to actuate the sample to alter the relative position of a sub-beam within a repeating patterned structure in the sample.
Clause 30. The charged particle apparatus of any of clauses 25 to 29, wherein the stage comprises a plurality of sub-stages, wherein at least two of the plurality of sub-stages are configured to actuate at least two of the plurality of samples independently of each other, desirably wherein each sub-stage is disposed at a corresponding sample position.
Clause 31. The charged particle apparatus of any preceding clause, wherein the stage comprises a coarse actuator configured to actuate more than one of the plurality of sample positions, desirably configured to actuate more than one of the plurality of sample positions collectively, desirably to actuate all of the plurality of samples collectively.
Clause 32. The charged particle apparatus of clause 30, wherein the coarse actuator is configured to actuate the stage in at least one translational degree of freedom, desirably to in a direction in a plane across, desirably perpendicular to, the path of a beam grid of a device of the array of devices.
Clause 33. The charged particle apparatus of clause 31 or 32, wherein the at least one sub-stage is supported by the coarse actuator and configured to actuate a corresponding sample position relative to the coarse actuator.
Clause 34. The charged particle apparatus of any of clauses 31 to 33, wherein the coarse actuator is configured to actuate at least one of the sample positions to alter the relative position of beams of the beam grids between different positions on the sample surface of the sample at the sample position, such different positions being different dies of the sample, desirably scanning the sample at the different positions at different times.
Clause 35. The charged particle apparatus of any preceding clause, wherein the stage comprises a plurality of sample supports configured to support a substrate at a sample position.
Clause 36. The charged particle apparatus of clause 35, wherein the different sample supports are configured to be actuated relative to the stage, desirably at least two different sample supports of the stage are configured to be actuated relative to each other, at least one desirably at least two different sample supports being configured to be actuated relative to the stage.
Clause 37. The charged particle apparatus of clause 35 or 36, wherein the sample supports are arranged in a sample support array of a two dimensional array on the stage across a beam grid path of at least one of the charged particle optical devices of the array of charged particle optical devices, desirably the sample support array is in a plane across, and desirably that is orthogonal to, the beam grid path of at least one of the charged particle optical device of the array of charged particle optical devices.
Clause 38. The charged particle apparatus of any of clauses 34 to 36, wherein the sample support array comprises a sample support that has two or more lines of at least three adjoining samples, the two or more lines being different lines of sample supports in the sample support array, and the two or more lines of sample supports having different directions in the sample support array.
Clause 39. The charged particle apparatus of clause 37 or 38, wherein at least one of the supports of the sample support array is surrounded by other sample supports of the sample support array, desirably in four different directions of the plane, desirably the four directions comprising at least one pair of directions that oppose each other.
Clause 40. The charged particle apparatus of any preceding clause, wherein the objective lens is electrostatic.
Clause 41. The charged particle apparatus of any of any preceding clause, wherein each charged particle device is for sample assessment, desirably for sample inspection.
Clause 42. The charged particle apparatus of any preceding clause, further comprising a vacuum chamber, wherein the stage is disposed within the vacuum chamber.

The descriptions above are intended to be illustrative, not limiting. Thus, it will be apparent to one skilled in the art that modifications may be made as described without departing from the scope of the claims set out below.

## Claims

1. A charged particle apparatus for projecting multiple beam grids of charged particle beams towards a plurality of samples, the apparatus comprising:
a stage configured to support a plurality of samples at respective sample positions; and
an array of charged particle devices,
the charged particle devices being respectively configured to project a plurality of charged particle beams in a beam grid towards the respective the sample positions,
the charged particle devices respectively comprising an objective lens and a detector, the objective lens being configured to direct the beam grid of the charged particle device on a sample at the respective sample position, and the detector being configured to detect signal particles from the sample,
the stage being configured to be actuated relative to the array of charged particle devices,
the stage and the array of charged particle devices being configured such that the array of charged particle devices scan relative to the plurality of samples simultaneously.

2. The charged particle apparatus of claim 1, wherein the stage and array of charged particle devices are configured so that at least one of the plurality of sample positions is configured to be actuated relative to at least one of the charged particle devices.

3. The charged particle apparatus of claim 1 or 2, wherein the array of charged particle devices comprises a charged particle device that in a plane across a path of the beam grid of the device has two or more lines of at least three adjoining devices, the two or more lines being different lines of devices in the array, and the two or more lines having different directions in the array.

4. The charged particle apparatus of claim 4, wherein the array of charged particle devices comprises a charged particle device in a plane across a path of the beam grid of the device that is surrounded by adjoining devices, desirably in four different directions of the plane, desirably the four directions comprising at least one pair of directions that oppose each other.

5. The charged particle apparatus of any preceding claim, wherein the detector comprises a detector array, desirably the detector is disposed downbeam of the objective lens.

6. The charged particle apparatus of any preceding claim, wherein the array of charged particle device comprises a plurality of sets of charged particle device, wherein the sets of charged particle devices are configured to project a plurality of charged particle beams in a beam grid towards the respective the sample positions.

7. The charged particle apparatus of claim 6, wherein adjoining sets of charged particle device are spaced apart from each other.

8. The charged particle apparatus of claim 6 or 7, wherein in each set at least one of the charged particle optical devices is surrounded in a plane across the beam grid path of at least one of the charged particle optical devices, by others of the charged particle optical devices of the set.

9. The charged particle apparatus of any of claims 6 to 8, wherein the number of sets of charged particle devices is equal to the number of sample positions, desirably each set of charged particle devices is assigned to a different sample position.

10. The charged particle apparatus of any of claims 6 to 9, wherein the of sets of charged particle-optical devise are each configured to face towards a respective sample position, desirably a major surface of a sample supported by a sample support desirably at the respective sample position.

11. The charged particle apparatus of any preceding claim, wherein each charged particle device is configured to be individually actuated in at least one degree of freedom, desirably to be individually actuated in a direction along the beam grid path of the charged particle optical device desirably perpendicular to a major surface of a sample at the corresponding sample position, desirably to a plane of the major surface.

12. The charged particle apparatus of any preceding claim, wherein the charged particle devices respectively comprise one or more electron-optical elements configured to operate on the beams of the beam grid of the charged particle optical device, wherein the one or more electron-optical elements are configured to operate on the beam grid to actuate the beams of the beam grid relative to the respective sample position and/or the beam grid of other charged particle optical devices of the array of charged particle optical devices and/or the set of charged particle optical devices to which the respective charged particle optical device belongs.

13. The charged particle apparatus of any preceding claim, wherein at least the corresponding sample position is configured to actuate a sample in a rotational degree of freedom, desirably to rotate around a direction through, desirably perpendicular to, a plane of a major surface of a sample at a sample position, desirably relative to the path of a beam grid of at least one of the array of charged particle devices, desirably relative to the path of a beam grid of at least one of the set of charged particle devise assigned to the corresponding sample position.

14. The charged particle apparatus of any preceding claim, wherein at least the corresponding sample position is configured to actuate a sample in at least one translational degree of freedom, desirably to actuate the sample in a direction through, desirably orthogonal to, a plane of a major surface of a sample at a sample position, and/or desirably to actuate the sample in a direction across the path of a beam grid of at least one of the charged particle devices directed towards the sample position, for example parallel to a plane of a major surface of a sample at a sample position, desirably relative to the path of a beam grid of at least one of the array of charged particle devices, desirably relative to the path of a beam grid of at least one of the set of charged particle devise assigned to the corresponding sample position.

15. The charged particle apparatus of any preceding claim, wherein the stage comprises a coarse actuator configured to actuate more than one of the plurality of sample positions, desirably configured to actuate more than one of the plurality of sample positions collectively, desirably to actuate all of the plurality of samples collectively.
